Europäisches Patentamt

**European Patent Office**

Office européen des brevets

(19)

(11) **EP 1 324 497 B1**

(12) **EUROPEAN PATENT SPECIFICATION**

(45) Date of publication and mention
of the grant of the patent:
**29.09.2004 Bulletin 2004/40**

(51) Int Cl.$^7$: **H03M 3/00**

(21) Application number: **01830812.2**

(22) Date of filing: **27.12.2001**

(54) **Method for self-calibrating a frequency of a modulator circuit, and circuit using said method**

Verfahren zur Selbstkalibrierung einer Frequenz einer Modulatorschaltung, und dieses Verfahren anwendende Schaltung

Procédé d'autocalibration d'une fréquence d'un circuit modulateur, et circuit utilisant ce procédé

(84) Designated Contracting States:
**DE FR GB IT**

(43) Date of publication of application:
**02.07.2003 Bulletin 2003/27**

(73) Proprietor: **STMicroelectronics S.r.l.**
**20041 Agrate Brianza (Milano) (IT)**

(72) Inventors:
• **Gandolfi, Gabriele**
**27010 Siziano (PV) (IT)**

• **Colonna, Vittorio**
**27015 Landriano (PV) (IT)**
• **Baschirotto, Andrea**
**15057 Tortona (AL) (IT)**

(74) Representative: **Mittler, Enrico et al**
**Mittler & C. s.r.l.,**
**Viale Lombardia, 20**
**20131 Milano (IT)**

(56) References cited:
**US-B1- 6 232 901**

EP 1 324 497 B1

**Description**

The present invention relates to a method for self-calibrating a frequency of a modulator circuit, and circuit using said method, particularly but not exclusively a method for self-calibrating a frequency of center band of a band pass sigma - delta type modulator circuit.

The sigma - delta modulators, with high performance characteristics, are used in a various number of applications, such as, by way of example, in audio communication systems.

Particularly, said applications require high range dynamic characteristic, for example, by means of a digital resolution of twelve bits, a precise center band frequency, having a value often Mhz, a small physic dimension of the modulator and a low current consumption.

Sigma - delta type band passing multi bit modulators are used, exactly, to reach said performance and physic characteristics.

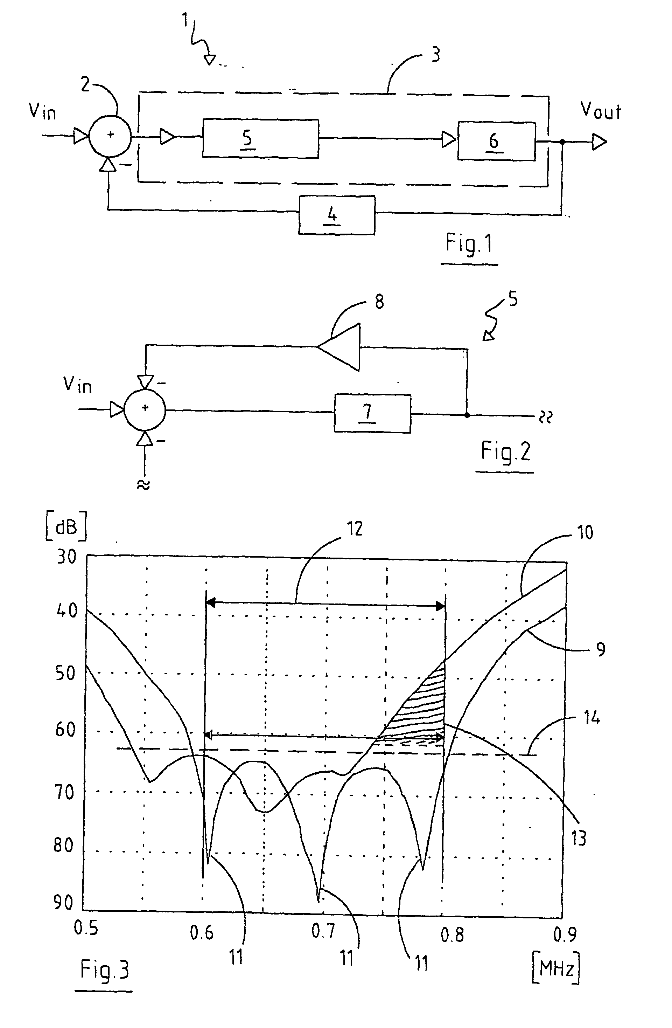

By referring to Figure 1, wherein a basic scheme of a sigma - delta modulator is shown, it is to be noted a loop circuit 1 composed by an adding node 2, a forward path 3 and a return path 4, also called feedback path.

Particularly in such a Figure 1 it is evident that the forward path 3 is realized by the series connection of a first block 5 with a second block 6, wherein said first block 5 is a filtering block and said second block 6 is an analog to digital conversion (ADC) block. The feedback path 4 is, instead, a digital to analog conversion (DAC) block.

The way of working of the circuit scheme of Figure 1 is well known to a skilled person and therefore it will not be shown.

In the modulator 1, the filtering block 5, in the easiest implementation, can be made, by way of example, according to an integrator filter scheme of the first order, as shown in Figure 2.

In fact in such a Figure 2 a detailed filtering block 5 according to the integrator filter scheme, also well known to a skilled person, is shown.

It is possible to note from such Figure 2, that the filtering block 5 is composed by a block 7, having in the feedback path an amplifier 8.

Particularly the block 7 is a discrete filter having as transfer function H(z) the following relationship:

$$H(z)=a_1*z^{-1}/(1-b_1*z^{-1}) \tag{1}$$

while the amplifier 8 has an opportune amplifying value suitable for the embodiment of the sigma - delta modulator.

By referring now to the Figure 3, wherein an output spectrum from a modulator having, as a filtering block, a filter of the third order is shown, there are to be noted an abscissa axis indicating the frequency evaluated in MHz, and an ordinate axis indicating the output noise spectrum evaluated in dB, a first graph 9, a second graph 10 and an observation band 12.

The first graph 9 is the output ideal spectrum of the third order modulator in the case of a solicitation at its input of impulsive type, that is in the case the modulator has ideal characteristics.

In fact, inside of such a band 12, for example the band of FM signals, it is possible to note the presence of three minimum points 11, that represent exactly the three notch frequencies introduced by each of the three discrete filters included in the forward path of the loop of the modulator.

The second graph 10 is, instead, the output real spectrum from the same third order modulator in the case of a solicitation at its input of impulsive type, when, that is, the phase errors and gain errors introduced by the devices or by the process spreads introduce a sort of shifting of the output ideal spectrum 9 to the output real spectrum 10.

It is just this shifting that produces the biggest problems of centering of the frequency.

As it can be deduced from such a Figure 3, when the integration operation is performed, also an extra energy 13 is integrated, that is present over a determined threshold level 14.

Such a level 14 is the thermal noise level, always present in the modulator, and the extra energy 13 is therefore that part of energy that is integrated unnecessarily, degrading the dynamic range.

A structure as heretofore described, by way of example that of Figure 2, has problems caused by the non ideality of the integrator filter 7, that introduces, in fact, phase errors and gain errors, depicted respectively by the coefficient $b_1$ and by the coefficient $a_1$ in the previous relationship (1), and gain and finite gain band product problems of the amplifier 8.

Various solutions have been proposed to solve such problems, among which there are techniques based on the master - slave concept, wherein there is a duplication of the circuitry so as to calibrate the first circuit in function of the errors of the second circuit, and compensating circuit techniques of the finite gain effects, also see US patent US 6,232,901.

However no technique has been able to prevent the previous listed factors from causing a shifting of the center frequency of the modulator 1 or an integration of undesired energy. Therefore, it is still present the problem of centering in the most precise possible way the center band frequency, without a degrading of the dynamic range.

In view of the state of the art described, an object of the present invention is to shift the most part of the circuitry in the digital domain so as to reduce to the minimum the analog elements to insert for the correction of the shifting factors of the center frequency and of the integration of a undesired energy.

According to the present invention, such object is achieved by a method for self-calibrating a frequency of a sigma - delta modulator, said sigma - delta modulator having a forward path and a feedback path, said forward path realized by the series connection of a resonator circuit and of an analog to digital conversion ADC block, said feedback path being realized by a digital to conversion DAC block, said method being characterized by comprising the following steps: a) to apply a pulse in input to said resonator circuit; b) to measure the oscillating frequency of the output signal from said resonator circuit in response to said pulse when the feedback path of said sigma - delta modulator is opened; c) to perform a comparison between said oscillating frequency of said resonator circuit with a frequency known a priori; d) to modify in a proportional way said oscillating frequency of said resonator circuit in function of said comparison performed at the previous step (c).

Such object is also obtained by a circuit for self calibrating a frequency, comprising a forward path and a feedback path, said forward path realized by the series connection of a resonator circuit and of an analog to digital conversion ADC block, said feedback path being realized by a digital to conversion DAC block, characterized in that said resonator circuit is composed by at least one integrator filter having in its feedback path a variable gain amplifier, said variable gain of said amplifier being modified in a proportional way in function of a comparison between the output signal frequency from said resonator circuit due to a pulse response present at its input and a frequency known a priori when said feedback path is opened.

Thanks to the present invention it is possible to make a method and a circuit to which an exact measure of the frequency inside an observation period is obtained.

The features and the advantages of the present invention will be made evident by the following detailed description of an embodiment thereof which is illustrated as not limiting example in the annexed drawings, wherein:

Figure 1 shows a basic scheme of a sigma - delta modulator, according to the prior art;
Figure 2 shows in detail a device of the Figure 1;
Figure 3 shows an output spectrum from a sigma - delta modulator of third order, according to the prior art;
Figure 4 shows a configuration of a sigma - delta modulator, according to the present invention;
Figure 5 shows a graph of the response to a pulse of the sigma - delta modulator shown in Figure 4;
Figure 6 shows a portion of the graph of Figure 5 in detail;
Figure 7 shows a circuit embodiment of the present invention.

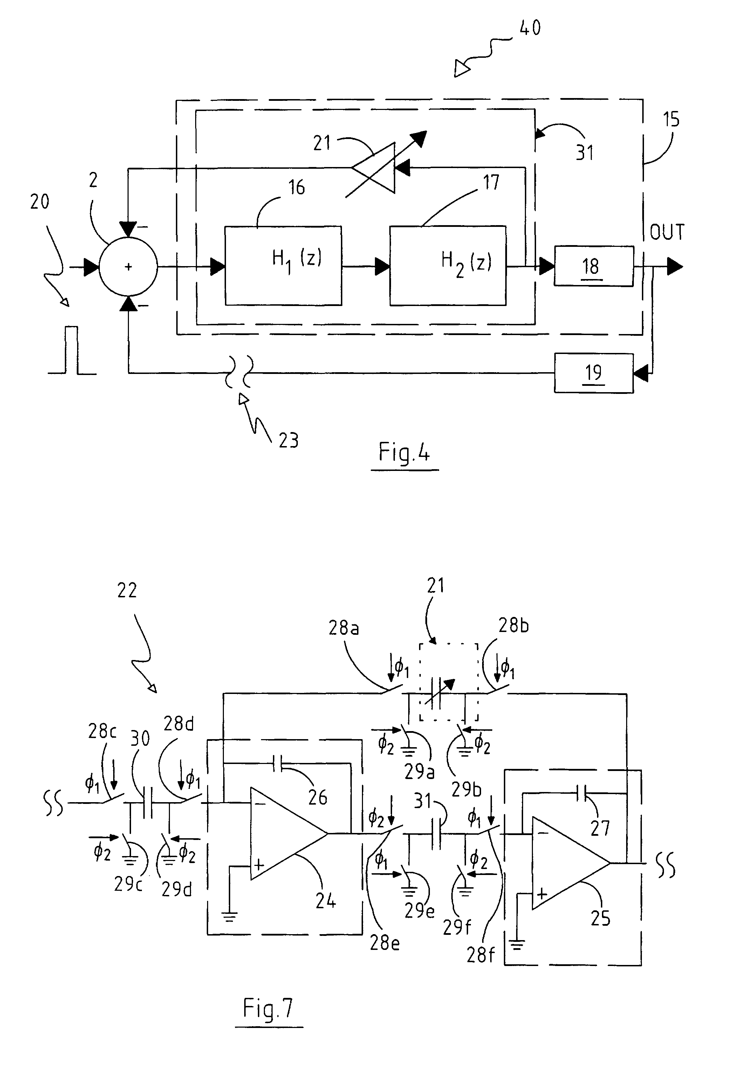

In Figure 4 a configuration 40 of a sigma - delta modulator of the second order is shown, wherein it is to be noted that the forward path 15 is realized by means of the series connection of a resonator circuit 31 and of a analog to digital conversion ADC block 18.

Said resonator circuit 31 is made by a first block 16 being in series with a second block 17, whereas said first 15 and second 16 blocks are filtering blocks having as transfer function a function equal as that shown in the relationship (1), and more precisely:

$$H_1(z) = a_1 {}^*z^{-1}(1 - b_1 {}^*z^{-1}) \tag{2}$$

$$H_2(z) = a_2 {}^*z^{-1}/(1 - b_2 {}^*z^{-1}) \tag{3}.$$

In feedback with said two blocks 16 and 17 there is an amplifier 21 variable in its own amplifying gain "g" in function of parameters that will described later.

Successively there is an analog to digital conversion block ADC 18, and in the feedback path there is a digital to analog conversion block DAC 19.

As it is to be noted the loop on the feedback path is open, point 23, and this allows to analyze the oscillating frequency of the resonator block 31 without the feedback due to the DAC block 19.

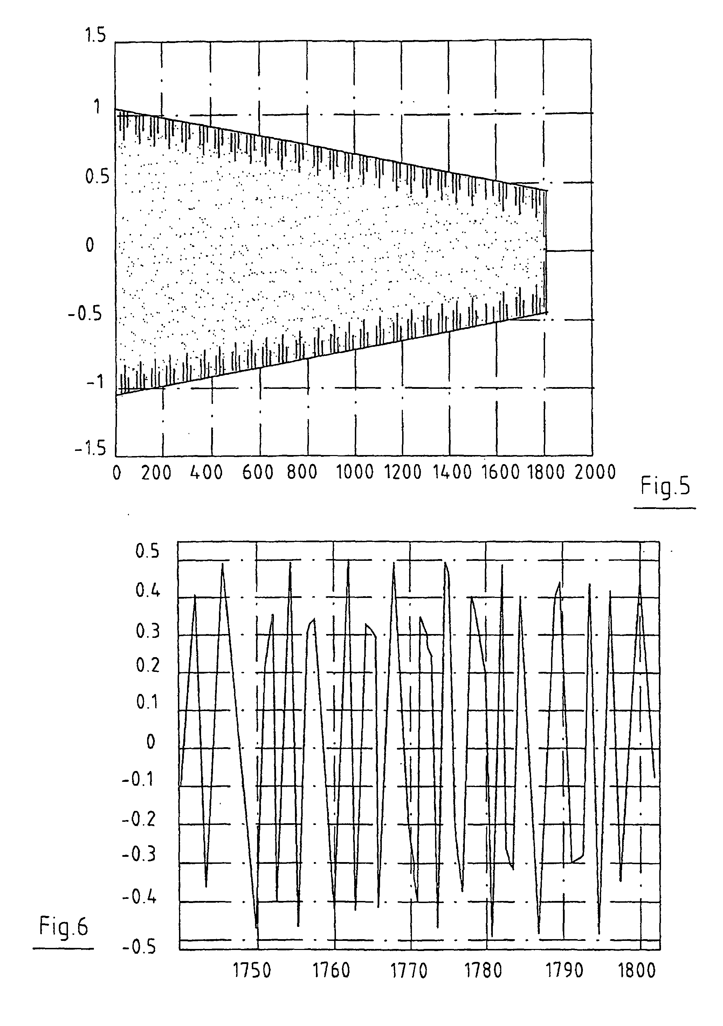

In fact, by applying a pulse 20 to the input IN of the adding node 2 when the feedback path is open, the series connection of the two filtering blocks 16 and 17 response with an output signal that assumes a shape of a damped sinusoid, as shown in the Figures 5 and 6, hereinafter described.

In fact, in order to obtain the pulse response of the two blocks 16 and 17 a zeta transform is used, so as to obtain an output signal having a relationship (for a detailed mathematic analysis refers to "Analog Mos Integrated Circuits for Signal Processing", ROUBIK GREGORIAN and GABOR C. TEMES, ed WILEY) of the following type:

$$y(n*T) = K*a_1*a_2*k^{n*T_g}*\sin(2*n*\pi*f_0*T_s)/[k^T*\sin(\omega_0*T_s)] \tag{4}$$

where k depends on the phase error of the two blocks 16 and 17, whilst $\omega_0$ depends on the amplifying coefficient "g" of the amplifier 21, $T_s$ is the sampling frequency and $f_0$ is the center band frequency of the two filters $H_1(z)$ and $H_2(z)$.

The frequency $f_0$ is the center band frequency of the sigma - delta band passing modulator 40 that is known a priori.

By way of example, the amplifying coefficient "g" is made by means of a capacitor array (not shown in Figure 4), wherein each one of the capacitor is connectable or disconnectable in parallel at the occurrence of specific conditions .

In this way it is possible to form a variable value of the amplifying coefficient "g", by making, exactly, a discrete type control of said amplifying value "g".

The relationship (4) shows that the damped sinusoid, generated due to application of the pulse 20, is correlated with the center band frequency $f_0$ of the sigma - delta band passing modulator 40.

It is this frequency $f_0$ that has to be maintained as precise as possible around its nominal value, penalty a dynamic degrading, and therefore the present invention allows to measure and eventually to correct the frequency $f_0$.

In Figure 5 the graph of the pulse response 20 of the resonator circuit 31 described in Figure 4 is shown, while in Figure 6 a detail portion of the graph of Figure 5 is shown.

Particularly the Figure 5 shows an abscissa axis showing the number of samples, and an ordinate axis showing the width of said samples.

The Figure 6 has the same axis showing the same quantity, with the characteristic of magnifying a range of samples, particularly the range of samples 1750 - 1800.

From the two Figures 5 and 6, it is possible to deduce that the pulse response of the forward path 1 5 of the modulator 40 of Figure 4 in a condition of open loop is equal to a damped sinusoid, the trend of which is exactly to flatten on the abscissa axis due to an infinite time observation.

In order to measure and eventually to correct the center band frequency $f_0$, first of all the feedback loop has to be opened and a pulse 20 has to be injected into the input IN. Due to this injection the resonator block 31 made by, for example, the switched capacitor filters $H_1(z)$ and $H_2(z)$, provides as response to the pulse 20 a damped sinusoid having a formula as the relationship (4). Successively, the oscillating frequency of said damped sinusoid (4) has to be measured, that is the crossings of the abscissa axis have to be counted in a prefixed period or observation period (or time). Finally, in function of the measured oscillating frequency or similarly the number of crossings of the abscissa axis, the value "g" of the amplifier 21 placed in feedback to the filters $H_1(z)$ and $H_2(z)$ has to be modified until the oscillating frequency of said damped sinusoid reaches the center band frequency fo.

The method thus described can be repeated until there is a perfect convergence between the oscillating frequency of the resonator circuit 31 and of the center band $f_0$ of the sigma - delta band passing modulator 40.

Therefore the present invention analyzes the oscillating frequency and corrects the difference between said measured oscillating frequency and the center band frequency $f_0$, by means of the correction of the amplifying value "g" of the amplifier 21.

This is possible because the number of crossings of the abscissa axis of the damped sinusoid is proportional to the center band frequency $f_0$.

To measure the crossings of the abscissa axis in a given period of time, that is to measure the oscillating frequency of the damped sinusoid described by the relationship (4), one of the comparators (not shown in Figure 4) present inside the ADC block 18 is used.

In other word the present invention foresees a computation of the crossings for the abscissa axis of the damped sinusoid by means of one of the comparators present inside the ADC block 18, successively it foresees a comparison between said number of counter with a number known a priori showing the number of crossings that should have been by taking into account the center band frequency $f_0$ as reference value and once said comparison is made, the amplifying value "g" of the amplifier 21 is modified by connecting or disconnecting capacitors in parallel, so as to converge to the ideal number of crossings represented by the center band frequency $f_0$.

Finally the amplifying value "g" is modified by converging the number of the crossings of the damped sinusoid to a desired threshold, represented by the center band frequency $f_0$.

The time period, during which the observation of the crossings for the abscissa axis by the damped sinusoid is performed, determines the precision of the counting of the number of crossings. In fact the longer the time period is, the less the measure inaccuracy is.

By way of example, assuming that $T_s$ is the sampling period, To is the oscillating period and $T_w$ is the window or time period of observation, the number N of crossings for the abscissa axis (either the crossing is made with positive or negative slope) is:

$$N=T_w/T_0 \qquad (5)$$

This number N of crossings is implemented, according to the present invention, in digital domain causing a better efficiency with respect of those systems realized in the prior art.

Referring again to the relationship (5) heretofore described, it is to be noted that the observation time $T_w$ depends particularly on the most stringent of two minimum times, that are: I°) minimum time required to obtain the desired resolution, that is the number of crossing, or oscillating frequency; II°) minimum time required to reduce the error of the number N with respect to the desired threshold of crossings.

The minimum time required to obtain the desired resolution is due to the intrinsic nature of the measure type and therefore said time afflicts every detecting system type and therefore also a system that uses a circuitry working in the analog domain, while the second minimum time required to reduce the error of the number N with respect to the desired threshold of crossings depends only by the nature of the sampled data, that is of the structure of the inventive method.

For the minimum time required the detecting of the oscillating frequency is limited by the precision that is to be adopted and it is given by the following relationships:

$$f_0=1/T_w \qquad (6)$$

$$T_w=1/\Delta f_0 \qquad (7).$$

This states that to solve the problem of the convergence to the center band frequency or notch $f_0$ with a resolution frequency $\Delta f_0$, the measurement window time has to be in accordance with relationship (7).

If, for example, a resolution of $\Delta f_0 < 20$ Khz is desired and taking into account the crossings of the abscissa axis with the positive slope, the measurement window has to be greater or equal to:

$$T_w \geq 1/\Delta f_0 \geq 50\mu\text{sec}$$

and in function of said relationship (8), taking into account as sigma-delta modulator a modulator having the characteristics of a clock or system frequency $f_{clock} = 37.05$ Mhz, of a center band or notch frequency $f_0 = 10.7$ Mhz and a resolution frequency $\Delta f_0 = 20$ Khz, it is to be deduced that the number samples for obtaining the desired resolution has to be equal to:

$$N=T_w*f_{clock}= 50\mu*37.05M=1800 \qquad (9)$$

For the minimum time adapted to reduce the error of the number N of samples with respect to the desired threshold of crossings, since the inventive system works with sampled data, the working time is made discrete while the observation window is not so, and therefore when the number N of crossings of the abscissa axis is evaluated an error is committed that has to be contained inside the desired resolution.

In other words there is intrinsic inaccuracy due to the sampling methodology so that there is a difference between the number N of crossings and the sampling period $T_s$.

Therefore, if, for example, a resolution frequency better than $\Delta f_0 = 20$ Khz is desired, that is a resolution around the center band frequency $f_0$ equal to for example at 0,2%, that is 20 KHz / 10.7 MHz = 0,2%, the maximum tolerated error is deduced by the following relationship:

$$N_r=(T_w-T_s)/T_0 \qquad (10)$$

where $N_r$ is the real number of the crossings for the abscissa axis, $T_w$ the period of the observation window, $T_s$ the

sampling period and $T_0$ the inverse center band frequency or the inverse notch frequency $f_0$.

By combining the relationship (5) with the relationship (10) the maximum tolerated error is exactly:

$$Err=(N-N_r)/N=T_s/T_w \qquad (11)$$

For example, if a sigma - delta modulator is again considered having such characteristics: a clock or system frequency $f_{clock}$ = 37.05 Mhz, of a center band or notch frequency $f_0$ = 10.7 Mhz and a resolution frequency $\Delta f_0$ = 20 Khz, that is an error equal to Err =20 KHz / 10.7 MHz = 0,2%, from the relationship (11) by putting, obviously, a more stringent limit, as for example 0,1%, the time period of the window has to be equal to:

$$T_w \geq T_s * 0.1\% \geq 26 \ \mu \qquad (12)$$

By comparing the limitation imposed from said relationship (12), that is the limitation imposed by the inventive method, that is $T_w$ grater or equal to 26 µsec, with the relationship (8), that is the limitation imposed by any measurement system, wherein the observation time $T_w$ has to be greater or equal to 50 µsec, it is to be deduced that the limitation imposed to the observation window is forced by the relationship (8).

A possible embodiment of a circuit 22 adapted to realize the present invention in Figure 7 is shown, wherein a switched capacitor circuit is described.

Particularly the circuit 22 is the electric implementation of the block 31 of Figure 4.

In fact, to be noted is the series connection of the two integrator filters 16 and 17 and of the amplifier 21 of variable gain "g".

Particularly, the integrator filters 16 and 17 are realized by using of respective inverting amplifiers 24 and 25, having as feedback device respective capacitors 26 and 27, whereas the amplifier 21 of variable gain "g" is realized by means of a capacitor array, the implementation of which is well known to a skilled person, and it is programmable in function of programming signals $\varphi_1$ and $\varphi_2$ adapted to switch the working state ON/OFF of respective switches 28a, 28b and 29a and 29b.

In said Figure 7 other circuit elements are equally shown such as an input capacitor 30 and a decoupling capacitor 31 between said two integrator filters 16 and 17.

Both the capacitors 30 and 31 are programmable in function of said programming signals $\varphi_1$ and $\varphi_2$ adapted to switch the state of respective switches.

Particularly the signals $\varphi_1$ and $\varphi_2$ program for the input capacitor 30 respectively the switches 28c, 28d and 29c and 29d, whilst for the decoupling capacitor 31 they program respectively the switches 28e, 28f and 29e and 29f.

Once by means of the inventive method the number of crossings of the abscissa axis is evaluated, once said number is compared with the nominal value known a priori, the eventual difference is used to calibrate the transfer function of the two integrator filters 16 and 17. Particularly the control is realized, as heretofore described, by means of the amplifying value "g" of the amplifier 21.

Substantially a self-calibrating or an automatic tuning operation of the resonator circuit 31 and therefore of the modulator 40 in function of the result of the comparison between the oscillating frequency and the center band frequency $f_0$ is realized.

In such a way it is possible to change in a proportional way the value of the oscillating frequency in function of the amplifying value "g" according to the following relationship:

$$f_0 = f_s*(g*a_1*a_2-b_1-b_2)/-2*r \qquad (13)$$

where $f_s$ is the sampling frequency, $a_1$, $b_1$, $a_2$ and $b_2$ are the errors introduced by the real integrator filters 16 and 17 and "r" is the radius of the position of the poles in the "z" plane.

For example, with the numerical values before introduced, the control of the amplifying value "g" is discrete and particularly in order to obtain a resolution frequency $\Delta f_0$ = 20 Khz every capacitor connectable in parallel must have a value of 21 fF so as that the oscillating frequency changes by a step of 20 KHz.

By assuming, for example, that the number of crossings calculated inside the observation window $T_w$ is equal to the number $N_1$ and the number of crossings known a priori is $N_2$ and due to the comparison between $N_1$ and $N_2$ there is a positive number then the combination of the signals $\varphi_1$ and $\varphi_2$ for the amplifier 21 provides that the amplifying factor "g" is modified by means of the connection of many capacitors as shown in said comparison, while if the comparison between $N_1$ and $N_2$ produces a negative number then the combination of the signals $\varphi_1$ and $\varphi_2$ for the amplifier

21 provides that the amplifying factor "g" is modified by means of the disconnection of many capacitors as shown in said comparison.

**Claims**

1. Method for self-calibrating a frequency of a sigma - delta modulator, said sigma - delta modulator (40) having a forward path (15) and a feedback path (19), said forward path (15) realized by the series connection of a resonator circuit (31) and of an analog to digital conversion ADC block (18), said feedback (19) path being realized by a digital to analog conversion DAC block (19), said method being **characterized by** comprising the following steps:

   a) to apply a pulse (20) in input (IN) to said resonator circuit (31);
   b) to measure, when the feedback path (19) of said sigma-delta modulator is opened, the oscillating frequency of the output signal (4) from said resonator circuit (31) in response to said pulse (20);
   c) to perform a comparison between said oscillating frequency of said resonator circuit (31) and a frequency ($f_0$) known a priori;
   d) to modify in a proportional way said oscillating frequency of said resonator circuit (31) in function of said comparison performed at the previous step (c).

2. Method according to the claim 1, **characterized in that** said steps (a) - (d) is iterated until said oscillating frequency of said resonator circuit (31) converges to said frequency ($f_0$) known a priori.

3. Method according to the claim 1, **characterized in that** said step (b) is realized by means of a counting operation of the crossings for the abscissa axis of said output signal (4) from said resonator circuit (31) in a time period ($T_w$).

4. Method according to the claim 3, **characterized in that** said counting operation is performed by means of a comparator present in said analog to digital conversion ADC block (18).

5. Method according to the claim 1, **characterized in that** said step (d) is realized by discrete modification of an amplifying gain ("g") of said resonator circuit (31).

6. Method according to the claim 5, **characterized in that** said resonator circuit (31) is realized by at least an integrator filter (16, 17) having in feedback at least an amplifier (21) with said amplifying gain ("g").

7. Method according to claim 6, **characterized in that** said amplifying gain ("g") of said at least an amplifier (21) is realized by means of a plurality of capacitors placed in parallel, connectable as a function of said comparison performed at the step (c) of the claim 1 by means of a plurality of controlling signals ($\varphi_1$, $\varphi_2$) adapted to control respective switches (28a, 28b, 29a, 29b).

8. Method according to claim 6, **characterized in that** said amplifying gain ("g") of said at least an amplifier (21) is realized by means of a plurality of capacitors placed in parallel, disconnectable as a function of said comparison performed at the step (c) of the claim 1 by means of a plurality of command signals ($\varphi_1$, $\varphi_2$) adapted to control respective switches (28a, 28b, 29a, 29b).

9. Method according to any of previous claims, **characterized in that** said step (d) is performed by the following relationship:

$$f_0 = f_s*(g*a_1*a_2-b_1-b_2)/-2*r$$

where "$f_s$" is the oscillating frequency of the output signal (4) from said resonator circuit (31), "$a_1$, $b_1$, $a_2$" and "$b_2$" are the introduced errors by the said at least one integrator filter (16, 17), "r" is the radius of the position of the poles in the "z" plane and "g" is said amplifying gain.

10. Circuit for self-calibrating a frequency comprising a forward path (15) and a feedback path (19), said forward path (15) realized by the series connection of a resonator circuit (31) and of an analog to digital conversion ADC block (18), said feedback (19) path being realized by a digital to analog conversion DAC block (19), said resonator circuit (31) being composed by at least one integrator filter (16, 17) having in its feedback path a variable gain ("g") amplifier (21), **characterized in that** said variable gain ("g") of said amplifier (21) is modified in a proportional way as a function of a comparison, performed when said feedback path (19) is opened, between the output signal frequency from said resonator circuit (31) due to a pulse (20) response present to its input (IN) and a frequency ($f_0$) known a priori.

11. Circuit according to the claim 10, **characterized in that** said at least a integrator filter (16, 17) is realized by at least one inverting amplifier (24, 25) having in feedback a prefixed value capacitor (26, 27) and said variable gain ("g") of at least one amplifier (21), said at least one inverting amplifier (24, 25) having its positive input terminal connected at ground and its negative input terminal connected to an input capacitor (30), said input capacitor (30) being controlled by a plurality of controlling signals($\varphi_1$, $\varphi_2$) adapted to control respective switches (28c, 28d, 29c, 29d).

12. Circuit according to claim 11, **characterized in that** said amplifying gain ("g") of said at least one amplifier (21) is realized by means of a plurality of capacitors placed in parallel, connectable as a function of said comparison performed at the step (c) of the claim 1 by means of a plurality of controlling signals ($\varphi_1$, $\varphi_2$) adapted to control respective switches (28a, 28b, 29a, 29b).

13. Circuit according to claim 11, **characterized in that** said amplifying gain ("g") of said at least one amplifier (21) is realized by means of a plurality of capacitors placed in parallel, disconnectable as a function of said comparison performed at the step (c) of the claim 1 by means of a plurality of command signals ($\varphi_1$, $\varphi_2$) adapted to control respective switches (28a, 28b, 29a, 29b).

## Patentansprüche

1. Verfahren zur Selbstkalibrierung einer Frequenz eines Sigma-Delta-Modulators, wobei der Sigma-Delta-Modulator (40) einen Vorwärtspfad (15) und einen Rückkopplungspfad (19) aufweist, der Vorwärtspfad (15) durch eine Reihenschaltung einer Resonatorschaltung (31) und eines Analog/Digitalwandler-ADC-Blocks (18) realisiert ist, der Rückkopplungspfad (19) durch einen Digital/Analogwandler-DAC-Block (19) realisiert ist, wobei das Verfahren durch Aufweisen der folgenden Schritte gekennzeichnet ist:

a) Anlegen eines Pulses (20) in Eingang (IN) an die Resonatorschaltung (31);
b) Messen, wenn der Rückkopplungspfad (19) des Sigma-Delta-Modulators offen ist, der Oszillationsfrequenz des Ausgabesignals (4) von der Resonatorschaltung (31) als Reaktion auf den Puls (20);
c) Durchführen eines Vergleichs zwischen der Oszillationsfrequenz der Resonatorschaltung (31) und einer zuvor bekannten Frequenz ($f_0$);
d) Modifizieren auf eine proportionale Weise der Oszillationsfrequenz der Resonatorschaltung (31) als Funktion des in dem vorherigen Schritt (c) durchgeführten Vergleichs.

2. Verfahren nach Anspruch 1, **dadurch gekennzeichnet, daß** die Schritte (a)-(d) iteriert werden, bis die Oszillationsfrequenz der Resonatorschaltung (31) zu der zuvor bekannten Frequenz ($f_0$) konvergiert.

3. Verfahren nach Anspruch 1, **dadurch gekennzeichnet, daß** der Schritt (b) mittels einer Zähltätigkeit der Kreuzungen der Abzissenachse des Ausgangssignals (4) von der Resonatorschaltung (31) in einer Zeitperiode ($T_w$) realisiert wird.

4. Verfahren nach Anspruch 3, **dadurch gekennzeichnet, daß** die Zähltätigkeit mittels eines Komparators durchgeführt wird, der in dem Analog/Digitalwandler-ADC-Block (18) vorhanden ist.

5. Verfahren nach Anspruch 1, **dadurch gekennzeichnet, daß** der Schritt (d) durch diskrete Modifikation eines Verstärkungsgewinnes ("g") der Resonatorschaltung (31) realisiert wird.

6. Verfahren nach Anspruch 5, **dadurch gekennzeichnet, daß** die Resonatorschaltung (31) durch mindestens ein Integrationsfilter (16, 17) realisiert wird, das in der Rückkopplung mindestens einen Verstärker (21) mit dem Verstärkungsgewinn ("g") aufweist.

7. Verfahren nach Anspruch 6, **dadurch gekennzeichnet, daß** der Verstärkungsgewinn ("g") des mindestens einen Verstärkers (21) mittels einer Mehrzahl von Kondensatoren realisiert wird, die verbindbar sind als eine Funktion des in dem Schritt (c) des Anspruchs 1 durchgeführten Vergleichs mittels einer Mehrzahl von Steuersignalen ($\varphi_1$, $\varphi_2$), die zum Steuern entsprechender Schalter (28a, 28b, 29a, 29b) ausgelegt sind.

8. Verfahren nach Anspruch 6, **dadurch gekennzeichnet, daß** der Verstärkungsgewinn ("g") des mindestens einen Verstärkers (21) mittels einer Mehrzahl von Kondensatoren realisiert wird, die parallel angeordnet sind, die trennbar sind als eine Funktion des in dem Schritt (c) von Anspruch 1 durchgeführten Vergleiches mittels einer Mehrzahl von Befehlssignalen ($\varphi_1$, $\varphi_2$), die zum Steuern entsprechender Schalter (28a, 28b, 29a, 29b) ausgelegt sind.

9. Verfahren nach einem der vorhergehenden Ansprüche, **dadurch gekennzeichnet, daß** der Schritt (d) durch die folgende Beziehung ausgeführt wird:

$$f_0 = f_s \cdot (g \cdot a_1 \cdot a_2 - bi - b_2)/-2 \cdot r$$

wobei "$f_s$" die Oszillationsfrequenz des Ausgangssignals (4) von der Resonatorschaltung (31) ist, "$a_1$, $b_1$, $a_2$" und "$b_2$" die Einführungsfehler durch das mindestens eine Integrationsfilter (16, 17) sind, "r" der Radius der Position der Pole in der "z"-Ebene ist und "g" der Verstärkungsgewinn ist.

10. Schaltung zur Selbstkalibrierung einer Frequenz mit einem Vorwärtspfad (15) und einem Rückkopplungspfad (19), wobei der Vorwärtspfad (15) durch die Reihenschaltung einer Resonatorschaltung (31) und eines Analog/Digitalwandler-ADC-Blocks (18) realisiert ist, der Rückkopplungspfad (19) durch einen Digital/Analogwandler-DAC-Block (19) realisiert ist, die Resonatorschaltung (31) durch mindestens ein Integrationsfilter (16, 17) zusammengesetzt ist, das in seinem Rückkopplungspfad einen Verstärker (31) variablen Gewinnes ("g") aufweist, **dadurch gekennzeichnet, daß** der variable Gewinn ("g") des Verstärkers (21) in einer proportionalen Weise modifiziert ist als eine Funktion eines Vergleichs, der durchgeführt wird, wenn der Rückkopplungspfad (19) offen ist, zwischen der Ausgangssignalfrequenz von der Resonatorschaltung (31) aufgrund eines Pulses (21) einer Reaktion, der an ihrem Eingang (IN) vorhanden ist und einer zuvor bekannten Frequenz ($f_0$).

11. Schaltung nach Anspruch 10, **dadurch gekennzeichnet, daß** das mindestens eine Integrationsfilter (16, 17) durch mindestens einen invertierenden Verstärker (24, 25) realisiert ist, der in seiner Rückkopplung einen Kondensator (26, 27) eines vorher fixierten Wertes und den variablen Gewinn ("g") des mindestens einen Verstärkers (21) aufweist, wobei der mindestens eine invertierende Verstärker (24, 25) einen positiven Eingangsanschluß, der mit Masse verbunden ist, und einen negativen Eingangsanschluß, der mit einem Eingangskondensator (30) verbunden ist, aufweist, der Eingangskondensator (30) durch eine Mehrzahl von Steuersignalen ($\varphi_1$, $\varphi_2$) gesteuert wird, die zum Steuern entsprechender Schalter (28c, 28d, 29c, 29d) ausgelegt sind.

12. Schaltung nach Anspruch 11, **dadurch gekennzeichnet, daß** der Verstärkungsgewinn ("g") des mindestens einen Verstärkers (21) mittels einer Mehrzahl von Kondensatoren realisiert ist, die parallel angeordnet sind, die als Funktion des in dem Schritt (c) des Anspruchs 1 durchgeführten Vergleichs mittels einer Mehrzahl von Steuersignalen ($\varphi_1$, $\varphi_2$) verbindbar sind, die zum Steuern entsprechender Schalter (28a, 28b, 29a, 29b) ausgelegt sind.

13. Schaltung nach Anspruch 11, **dadurch gekennzeichnet, daß** der Verstärkungsgewinn ("g") des mindestens einen Verstärkers (21) realisiert ist mittels einer Mehrzahl von Kondensatoren, die parallel angeordnet sind, die als eine Funktion des in dem Schritt (c) des Anspruchs 1 durchgeführten Vergleichs mittels einer Mehrzahl von Befehlssignalen ($\varphi_1$, $\varphi_2$) trennbar sind, die zum Steuern entsprechender Schalter (28a, 28b, 29a, 29b) ausgelegt sind.

**Revendications**

1. Procédé d'auto-étalonnage d'une fréquence d'un modulateur sigma-delta, le modulateur sigma-delta (40) ayant un trajet direct (15) et un trajet de réaction (19), le trajet direct (15) étant réalisé par la connexion en série d'un circuit résonateur (31) et d'un bloc (18) de conversion analogique-numérique, le trajet de réaction (19) étant réalisé par un bloc (19) de conversion numérique-analogique, ce procédé étant **caractérisé en ce qu'**il comprend les étapes suivantes :

a) appliquer une impulsion (20) à l'entrée (IN) du circuit résonateur (31) ;
b) mesurer, quand le trajet de réaction (19) du modulateur sigma-delta est ouvert, la fréquence d'oscillation du signal de sortie (4) du circuit résonateur (31) en réponse à ladite impulsion (20) ;

c) réaliser une comparaison entre la fréquence d'oscillation du circuit résonateur (31) et une fréquence ($f_0$) connue a priori ;

d) modifier de façon proportionnelle la fréquence d'oscillation du circuit résonateur (31) en fonction de la comparaison réalisée à l'étape (c) précédente.

2. Procédé selon la revendication 1, **caractérisé en ce que** les étapes (a) et (d) sont répétées jusqu'à ce que la fréquence d'oscillation du circuit résonateur (31) converge vers la fréquence ($f_0$) connue a priori.

3. Procédé selon la revendication 1, **caractérisé en ce que** l'étape (b) est réalisée par une opération de comptage des croisements de l'axe des abscisses du signal de sortie (4) du circuit résonateur (31) en une durée ($T_W$).

4. Procédé selon la revendication 3, **caractérisé en ce que** l'opération de comptage est réalisée par un comparateur présent dans le bloc (18) de conversion analogique-numérique.

5. Procédé selon la revendication 1, **caractérisé en ce que** l'étape (d) est réalisée par modification discrète du gain d'amplification ("g") du circuit résonateur (31).

6. Procédé selon la revendication 5, dans lequel le circuit résonateur (31) est réalisé par au moins un filtre intégrateur (16, 17) ayant en réaction au moins un amplificateur (21) de gain d'amplification "g".

7. Procédé selon la revendication 6, **caractérisé en ce que** le gain d'amplification "g" dudit au moins un amplificateur (21) est réalisé par une pluralité de condensateurs en parallèle, connectables en fonction de la comparaison réalisée à l'étape (c) de la revendication 1 au moyen d'une pluralité de signaux de commande ($\varphi1$, $\varphi2$) adaptés à commander des commutateurs respectifs (28a, 28b, 29a, 29b).

8. Procédé selon la revendication 6, **caractérisé en ce que** le gain d'amplification ("g") dudit au moins un amplificateur (21) réalisé au moyen d'une pluralité de condensateurs en parallèle, déconnectables en fonction de la comparaison réalisée à l'étape (c) de la revendication 1 au moyen d'une pluralité de signaux de commande ($\varphi1$, $\varphi2$) adaptés à commander des commutateurs respectifs (28a, 28b, 29a, 29b).

9. Procédé selon l'une quelconque des revendications précédentes, **caractérisé en ce que** l'étape (d) est réalisée par la relation suivante :

$$f_0 = f_s*(g*a_1*a_2-b_1-b_2)/-2*r$$

où "$f_s$" est la fréquence d'oscillation du signal de sortie (4) du circuit résonateur (31), "$a_1$, $b_1$, $a_2$" et "$b_2$" sont les erreurs introduites par ledit au moins un filtre intégrateur (16, 17), "r" est le rayon de la position des pôles dans le plan "z", et "g" est le gain d'amplification.

10. Circuit d'auto-étalonnage d'une fréquence comprenant un trajet direct (15) et un trajet de réaction (19), le trajet direct (15) étant réalisé par la connexion en série d'un circuit résonateur (31) et d'un bloc (18) de conversion analogique-numérique, le trajet de réaction (19) étant réalisé par un bloc (19) de conversion numérique-analogique, le circuit résonateur (31) étant composé d'au moins un filtre intégrateur (16, 17) ayant dans son trajet de réaction un amplificateur (21) de gain variable ("g"), **caractérisé en ce que** le gain variable ("g") de l'amplificateur (21) est modifié de façon proportionnelle en fonction d'une comparaison, réalisée quand le trajet de réaction (19) est ouvert, entre la fréquence du signal de sortie du circuit résonateur (31) due à une réponse en impulsion (20) présente sur son entrée (IN) et une fréquence ($f_0$) connue a priori.

11. Circuit selon la revendication 10, **caractérisé en ce que** ledit au moins un filtre intégrateur (16, 17) est réalisé par au moins un amplificateur inverseur (24, 25) ayant en réaction un condensateur de valeur prédéterminée (26, 27) et le gain variable ("g") dudit au moins un amplificateur (21), ledit au moins un amplificateur inverseur (24, 25) ayant sa borne d'entrée positive connectée à la masse et sa borne d'entrée négative connectée à un condensateur d'entrée (30), le condensateur d'entrée (30) étant commandé par une pluralité de signaux de commande ($\varphi1$, $\varphi2$) adaptés à commander des commutateurs respectifs (28c, 28d, 29c, 29d).

12. Circuit selon la revendication 11, **caractérisé en ce que** le gain d'amplification ("g") dudit au moins un amplificateur (21) est réalisé au moyen d'une pluralité de condensateurs en parallèle connectables en fonction de la comparaison réalisée à l'étape (c) de la revendication 1 au moyen d'une pluralité de signaux de commande (φ1, φ2) adaptés à commander des commutateurs respectifs (28a, 28b, 29a, 29b).

13. Circuit selon la revendication 11, **caractérisé en ce que** le gain d'amplification ("g") dudit au moins un amplificateur (21) est réalisé au moyen d'une pluralité de condensateurs en parallèle, déconnectables en fonction de la comparaison réalisée à l'étape (c) de la revendication 1 au moyen d'une pluralité de signaux de commande (φ1, φ2) adaptés à commander des commutateurs respectifs (28a, 28b, 29a, 29b).

Fig.1

Fig.2

Fig.3

Fig.4

Fig.7

Fig.5

Fig.6